# EUROPEAN PATENT APPLICATION

(11) **EP 4 832 035 A1**
(43) Date of publication of application: **28.10.2026**
(21) Application number: 25171879.7
(22) Date of filing: 23.04.2025
(51) Int. Cl.: H01H 3/46, H01H 33/666, G06F 30/23

(54) **GAS-INSULATED HIGH-VOLTAGE APPARATUS HAVING SOLID INSULATING ELEMENT WITH SELF-SHIELDING SURFACE STRUCTURES**

(71) Applicant: ABB SCHWEIZ AG, 5400 Baden (CH)
(72) Inventor: ENGEL, Edgar Albert, 3008 Bern (CH); YANG, Chia-Jung, 8048 Zurich (CH); SAUER, Manfred, 40885 Ratingen (DE)
(74) Representative: Maiwald GmbH

(57) **Abstract**

The invention relates to a gas-insulated high-voltage apparatus (10), which comprises at least one conducting element, arranged in at least one gaseous environment (15), a solid insulating element (100) and a finite element analysing module. The solid insulating element (100) comprises a surface (115), exposing to the gaseous environment (15) and configured to mechanically support and/or electrically separate the at least one conducting element, and a plurality of surface structures (116), arranged at and integrally forming the surface (115). The finite element analysing module is configured to analyse the surface (115) and the plurality of surface structures (116) and to determine the plurality of surface structures (116) to be dimensioned and spaced based on at least one geometry constraint of the solid insulating element (100). The plurality of surface structures (116) are designed to allow generating a mutual shielding among the plurality of surface structures (116) under an electric field stress over the surface (115), in order to reduce the electric field stress at the surface (115) of the solid insulating element (100) below a predetermined electric field stress limit.

## Description

### FIELD OF INVENTION

The present disclosure relates to a gas-insulated high-voltage apparatus, a push-rod assembly configured to actuate a vacuum interrupter for a gas-insulated high-voltage apparatus, the use of a gas-insulated high-voltage apparatus and/or a push-rod assembly, a method for reducing a surface electric field stress for a gas-insulated high-voltage apparatus, a computer program and a processing system.

### BACKGROUND

High-voltage vacuum- and gas-insulated apparatus commonly require control of electric field stress across various internal components, particularly at the interface between solid insulating elements and the surrounding insulating gas. In gas-insulated high-voltage systems, such as switchgears, electrodes at different electrical potentials may be reliably supported and electrically separated within gaseous environments. This function may typically be achieved by structural insulating components such as spacers or brackets.

These insulating components may, however, be frequently exposed to elevated electric field stress at their surfaces, especially at the gas-insulator interface. Such stress concentrations may lead to partial discharges, discharge inception, and ultimately dielectric breakdown. Failures of this kind may often be abrupt, destructive, and costly, and their prevention is strictly governed by international certification standards for gas-insulated apparatus.

Conventional methods for mitigating dielectric breakdown may include modifying the gas composition, though this may increasingly be constrained by environmental and regulatory considerations, or increasing the gas filling pressure. Additionally, supplementary electrode structures may be introduced to redistribute the electric field. However, such solutions may add considerable complexity and cost, for example by requiring stronger pressure vessels or custom-designed electrode mounting arrangements.

The challenge may further be amplified in the case of solid insulating components formed from polarizable polymeric materials, which are prone to field enhancement at geometrically constrained areas, particularly at high-curvature surfaces. These design constraints may often be dictated by manufacturing limitations, such as minimum wall thickness required to avoid gas inclusions and voids during injection molding.

Alternative strategies, including surface coatings, material treatments, or advanced profiling of insulating surfaces, may offer limited mitigation. Yet these may also introduce additional material costs, processing complexity, and potential reliability concerns.

### SUMMARY

It may be seen as an objective of the invention to provide an improved high-voltage vacuum- and gas-insulated apparatus with an increased safety system under high electric field with a simplified construction and reduced manufacturing costs.

The objective is achieved by the subject matter of the independent claims. The dependent claims, the following description and the drawings show embodiments of the invention.

According to a first aspect of the present disclosure, a gas-insulated high-voltage apparatus is provided, which comprises at least one conducting element, which is arranged in at least one gaseous environment, a solid insulating element and a finite element analysing module. The solid insulating element comprises a surface, which exposes to the gaseous environment and is configured to mechanically support and/or electrically separate the at least one conducting element, and a plurality of surface structures, which are arranged at and integrally forming the surface.

For example, the gaseous environment may be understood broadly as a gas-filled compartment or chamber, in which both the conducting element and the solid insulating element may be arranged, or a vacuum chamber, or an atmosphere air, which may allow an open installation of the conducting element and the solid insulating element.

The finite element analysing module is configured to analyse the surface and the plurality of surface structures and to determine the plurality of surface structures to be dimensioned and spaced based on at least one geometry constraint of the solid insulating element. The plurality of surface structures are designed to allow generating a mutual shielding among the plurality of surface structures under an electric field stress over the surface, in order to reduce the electric field stress at the surface of the solid insulating element below a predetermined electric field stress limit.

The gas-insulated high-voltage apparatus may be, but not limited to, a gas-insulated switchgear (GIS), a gas-insulated circuit breaker, a gas-insulated busbar system, a gas-insulated transformer, a gas-insulated disconnect switch, or any combination thereof. Alternatively, a vacuum-insulated high-voltage apparatus may be provided. A high-voltage apparatus may be an electrical device designed to operate at voltages typically above 1,000 volts, used for power transmission, distribution, control, or insulation in industrial and utility systems. The at least one conducting element may comprise, for example, one or more electrodes, conductors, terminals, contact arms, busbars, or connecting leads.

The gas-insulated high-voltage apparatus of the present disclosure having the adaptively dimensioned and/or spaced surface structures may allow exploiting the polarization and resultant mutual shielding of the insulating elements under applied voltage or field stress, in order to minimize surface electric field stress, while maintaining the same overall spatial footprint.

According to another embodiment, the at least one geometry constraint of the solid insulating element of the gas-insulated high-voltage apparatus may comprise a maximum radius of curvature of the plurality of surface structures defined by a manufacturing process of the solid insulating element, and/or a maximum wall thickness of the plurality of surface structures and/or the solid insulating element permitted to prevent an inclusion of gas voids, and/or a mechanical strength requirement defining a minimum cross-sectional dimension of the plurality of surface structures of the solid insulating element.

According to another embodiment, the plurality of surface structures may comprise high-curvature surfaces.

With gas-insulated high-voltage apparatus of the present disclosure having the adaptively dimensioned and/or spaced surface structures, the need for field-control electrodes to reduce field stress on solid-insulating parts may advantageously be eliminated, by exploiting the mutual shielding between surfaces of such a polarizable solid insulating element component. This may particularly be relevant, when production processes, such as injection molding, impose limitations on the wall thickness and thus minimal radii of curvature of exposed surfaces, as for electrodes high curvatures on exterior surfaces generally produces high field enhancement and thus field stress, which in turn may bear the risk of discharge inception and subsequent catastrophic dielectric breakdown under applied voltage stress.

According to another embodiment, the solid insulating element of the gas-insulated high-voltage apparatus may be made of a polymer-based insulating material having a relative permittivity greater than the gaseous environment.

The polymer-based insulating material may be, but not limited to, a polyamide (PA) or a polyphenylene sulfide (PPS) or a thermoset resin.

It may be noted that high-curvature surfaces may practically be unavoidable when the wall thickness of the insulating components may be limited by the risk of microscopic gas inclusions and voids in the insulating material, which in turn may be prone to partial discharge and accelerated ageing, leading to failures to withstand. A common example of this are, for example e.g. a PA component produced by an injection molding process. Notably the choice of materials may be limited by many factors, including material compatibility, mechanical properties, ageing considerations, fire resistance, available manufacturing methods, costs, etc.

According to another embodiment, the finite element analysing module may be configured to determine a spacing between adjacent surface structures of the plurality of surface structures based on at least one parameter, which may comprise the relative permittivity of the insulting material greater than the gaseous environment, and/or a permissible electric field stress determined by a gas filling the at least one gaseous environment and/or a gas pressure in the at least one gaseous environment, and/or a degree of field enhancement determined by permissible dimensions of the plurality of surface structures of the insulating element.

In other words, the optimal spacing between high-curvature surfaces is adapted to (i) the relative permittivity of the chosen insulator material greater than the gaseous environment, (ii) the permissible field stress as determined by the choice of gas and filling pressure, and (iii) the degree of field enhancement as determined by the permissible dimensions of the insulating structure, which may be determined e.g. by mechanical requirements and the wall thickness that can be achieved at low risk of inclusion of gas bubbles or voids.

The resultant field control by self-shielding may constitute a simple to implement, low-cost alternative to the traditional dedicated field-control electrodes that would have to be included in addition at the price of increased production costs and complexity.

According to another embodiment, the solid insulating element of the gas-insulated high-voltage apparatus may be a push-rod assembly, which may comprise an elongated push-rod body and configured to actuate a vacuum interrupter for the gas-insulated high-voltage apparatus. The plurality of surface structures may comprise a plurality of longitudinal ribs at the surface extending along the elongated push-rod body.

Advantageously, the providing of the adaptive rib or insulator surface spacing may be designed to enhance the dielectric performance without necessitating complex and costly modifications to the assembly and while maintaining the same overall spatial footprint. It may thus tackle the widespread and critical problem of surface discharge inception on insulating mechanical structures arising from field enhancement due to high surface curvatures, as required by manufacturing processes.

Further, the push-rod assembly as the solid insulating element may permit substantially reducing the electrical stress on such surfaces, which may be the key predictor and cause for discharge inception, without increasing the complexity of devices in terms of number of parts, manufacturing processes, or the like.

According to a second aspect, a push-rod assembly is provided, which is configured to actuate a vacuum interrupter for a gas-insulated high-voltage apparatus of the present disclosure. The push-rod assembly comprises an elongated push-rod body as the solid insulating element, and a plurality of longitudinal ribs as the plurality of surface structures. The plurality of longitudinal ribs comprise a cross-sectional dimension, which is determined by means of the finite element analysing module, each of which has a height and a wall thickness.

The plurality of longitudinal ribs are arranged at and extending along the elongated push-rod body. The plurality of longitudinal ribs integrally form the surface of the elongated push-rod assembly.

Further, the plurality of longitudinal ribs may be equally spaced at the spacing, which may be determined by means of the finite element analysing module, and designed to allow generating a mutual shielding between adjacent ribs of the plurality of longitudinal ribs under the electric field stress, in order to reduce a peak electric field stress at each of the plurality of longitudinal ribs at the surface of the push-rod assembly below a predetermined electric field stress limit.

In this way, mechanically-required, longitudinal ribs surface structures as solid insulating elements on the elongated push-rod body of the push-rod assembly or actuator may be provided for the vacuum interrupter, for example, in a gas-insulated switchgear, and adaptively spaced such as to minimize surface electric field stress, while maintaining the same overall spatial footprint.

According to another embodiment, the push-rod assembly may further comprise a spring cup and a pole insert. The spring cup may be arranged at a first end of the elongated push-rod body, configured to connect to an operating mechanism and to drive the push-rod body towards the vacuum interrupter. The pole insert may be arranged at a second end opposite to the first end of the elongated push-rod body and configured to connect to the vacuum interrupter.

An electric potential of the spring cup may be different than an electric potential of the pole insert.

The optimal spacing between the high-curvature ribs surface structures on the surface may be adapted to (i) the relative permittivity of the chosen insulator material greater than the gaseous environment, (ii) the permissible field stress as determined by the choice of the gas and the filling pressure, and (iii) the degree of field enhancement as determined by the permissible dimensions of the insulating surface structure, which may be determined, for example, by mechanical requirements and the wall thickness that can be achieved at low risk of inclusion of gas bubbles or voids.

The resultant field control by the self-shielding effect provided by the adaptively spaced ribs surface structures may constitute a simple to implement, low-cost alternative to the traditional dedicated field-control electrodes that would have to be included in addition at the price of increased production costs and complexity.

According to another embodiment, the wall thickness of each of the plurality of longitudinal ribs may be determined, by means of the finite element analysing module, to be equal to or less than 4 mm for preventing the inclusion of gas voids.

The manufacturing process of the push-rod body may be an injection molding process. Alternatively, the manufacturing process of the push-rod body may be an injection casting process, which may require different materials used, different mechanical setups and applications than the injection molding process.

According to another embodiment, the height of the plurality of longitudinal ribs may be determined, by means of the finite element analysing module, to be in the range of 2 mm to 8 mm. Alternatively or additionally, the spacing between the plurality of longitudinal ribs may be determined, by means of the finite element analysing module, to be less than 6 mm. The peak electric field stress at the surface of the push-rod assembly may be below the predetermined electric field stress limit of 2 kV/mm.

Moreover, the spacing between the plurality of longitudinal ribs may be determined, by means of the finite element analysing module, to be in the range of up to 8 mm.

For example, finite-element simulations of electrical fields may be performed to demonstrate the optimal dimensioning of such ribs surface structures for given material-related constraints, such as maximum wall thickness, given mechanical requirements, such as minimal cross-section, and given placement in a general device geometry. The simulation results with the peak field stress, which may be realized on top of the maximally rounded or high-curvature ribs surface structures having a certain wall thickness, for example 4 mm, as a function of rib height and spacing and may demonstrate that surface field stresses may be reduced substantially by adapting the ribs spacing to the rib height.

Such simulations may play a key role in calculating and visualizing the electrical stress under defined operational conditions and generalize to different and complex industrial device geometries. More importantly, the concept of exploiting the mutual shielding of insulator surfaces may generalize to such complex device geometries.

According to a third aspect, there is provided the use of a gas-insulated high-voltage apparatus of the present disclosure or a push-rod assembly of the present disclosure for preventing discharge inception and dielectric breakdown as a result of a surface electric field stress.

According to another aspect, there is provided a method for reducing a surface electric field stress for a gas-insulated high-voltage apparatus, which comprises at least one conducting element being arranged in at least one gaseous environment. The method comprises the following steps:
- providing a solid insulating element, comprising a surface exposing to the gaseous environment and configured to mechanically support and/or electrically separate the at least one conducting element and a plurality of surface structures being arranged at and integrally forming the surface;
- analysing the surface and determining, by means of a finite element analysing module, the plurality of surface structures to be dimensioned and spaced based on at least one geometry constraint of the solid insulating element;
- allowing generating a mutual shielding among the plurality of surface structures under an electric field stress over the surface, thereby reducing the electric field stress at the surface of the solid insulating element below a predetermined electric field stress limit.

The at least one geometry constraint of the solid insulating element comprises a maximum radius of curvature of the plurality of surface structures defined by a manufacturing process of the solid insulating element, and/or a maximum wall thickness of the plurality of surface structures and/or the solid insulating element permitted to prevent from an inclusion of gas voids, and/or a mechanical strength requirement defining a minimum cross-sectional dimension of the plurality of surface structures of the solid insulating element.

According to an embodiment, the step of analysing the surface and determining, by means of the finite element analysing module, the plurality of surface structures to be dimensioned and spaced may comprise the substeps of:
- determining, by means of the finite element analysing module, a spacing between adjacent surface structures of the plurality of surface structures based on at least one parameter comprising a relative permittivity of an insulting material of the solid insulating element greater than the gaseous environment, and/or a permissible electric field stress determined by a gas filling the at least one gaseous environment and/or a gas pressure in the at least one gaseous environment, and/or a degree of field enhancement determined by permissible dimensions of the plurality of surface structures of the insulating element;
- adjusting, by means of the finite element analysing module, a cross-sectional dimension of each of the plurality of surface structures comprising a height and the wall thickness and/or the spacing between the adjacent surface structures of the plurality of surface structures, in order to reduce the peak electric field stress at the surface below the predetermined electric field stress limit.

For example, the surface electric field stress may be optimized or adjusted on two iterations of an insulating push-rod for actuating a vacuum interrupter. In the first iteration, the surface of the insulating elements may not actively exploit the mutual shielding of the mechanically required longitudinal ribs, which may be provided in a vicinity of a pole insert of the push-rod assembly with sparsely arranged first groups of rib surface structures, which may not be thicker than around 4 mm due to avoid excessive risk of gas inclusion and voids during the injection molding process used for production. Consequently, significant field enhancement and high field stress may occur on the longitudinal ribs, possibly leading to a discharge inception. By contrast, in the second iteration, the optimized solution with the additional, adapted and much tighter spacing of the second group of longitudinal ribs surface structure at the surface in a region corresponding to a transition region between the push-rod body and the spring cup may advantageously capitalize on their mutual shielding upon the voltage application. In this way, a reduction of field stress may be achieved by around 20% with respect to the first iteration, while the part of the insulating element or the push-rod body may still be produced using the same production techniques.

According to another aspect, there is provided a computer program that comprises machine-readable instructions that, when executed by one or more data processing apparatus comprising a finite element analysing module, cause the one or more data processing apparatuses to perform a method of the present disclosure.

There may be provided a non-transitory machine-readable data carrier and/or a download product with the computer program. A download product is an instance of the computer program that may be sold and downloaded online for immediate fulfilment in lieu of physically shipping a machine-readable data carrier.

The method may be at least partly computer-implemented, and may be implemented in software or in hardware, or in software and hardware. Further, the method may be carried out by computer program instructions running on means that provide data processing functions. The data processing means may be a suitable computing means, such as an electronic control module etc., which may also be a distributed computer system. The data processing means or the computer, respectively, may comprise one or more of a processor, a memory, a data interface, or the like.

According to another aspect, it may be provided a data processing system that is configured to carry out the method of the present disclosure.

It should be noted that the above examples may be combined with each other irrespective of the aspect involved. Accordingly, the method may be combined with structural features and, likewise, the apparatus and the system may be combined with features described above with regard to the method.

These and other aspects will be apparent from and elucidated with reference to the embodiments as per the drawings described hereinafter.

### BRIEF DESCRIPTION OF THE FIGURES

Examples of the disclosure will be described in the following with reference to the following drawings.
- Fig. 1: shows schematically an example of a gas-insulated high-voltage apparatus according to the present disclosure;
- Fig. 2: shows schematically an example of a push-rod assembly for a gas-insulated high-voltage apparatus according to the present disclosure;
- Fig. 3a: shows schematically an example of a push-rod assembly having self-shielding rib surface structures according to the present disclosure;
- Fig. 3b: shows schematically an example of a push-rod assembly having self-shielding surface structures according to the present disclosure;
- Fig. 4a: shows schematically an example of geometric parameters of a self-shielding rib surface structures of an elongated push-rod body of a push-rod assembly according to the present disclosure;
- Fig. 4b: shows schematically an example of a two-dimensional model with rib surface structures exposed to a high-voltage potential (HV) and grounded plate (GND) simulating the field shielding effect according to the present disclosure;
- Fig. 4c: shows graphically a simulation-based correlation diagram of a peak electric field stress relative to a height and a spacing of ribs surface structures according to the present disclosure;
- Fig. 5: shows schematically a flow chart illustrating a method for reducing a surface electric field stress for a gas-insulated high-voltage apparatus according to the present disclosure;

The figures are merely schematic representations and serve only to illustrate examples of the disclosure. Identical or equivalent elements are in principle provided with the same reference signs.

### DETAILED DESCRIPTION OF EMBODIMENTS

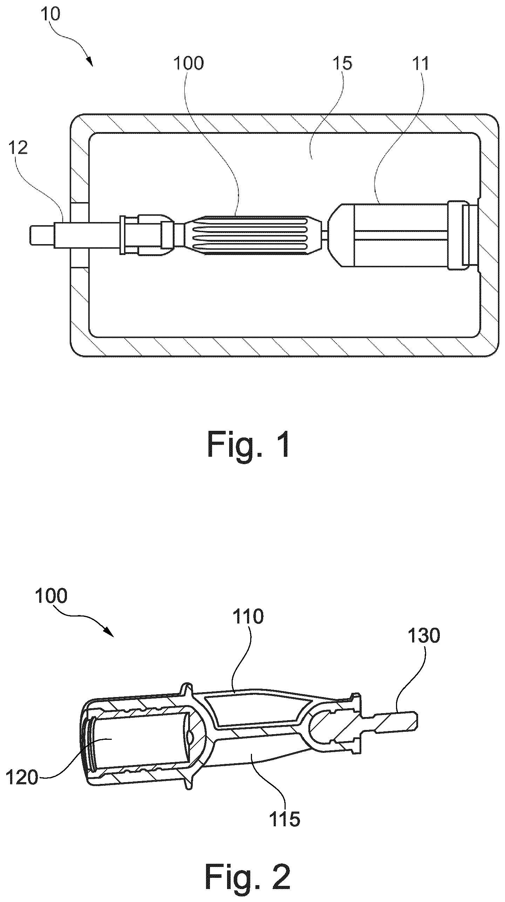

Fig. 1 shows schematically an example of a gas-insulated high-voltage apparatus 10 of the present disclosure, which comprises at least one conducting element that may be arranged in at least one gaseous environment, and a solid insulating element 100. In addition, the gas-insulated high-voltage apparatus 10 may further comprise a vacuum interrupter 11, which is arranged inside the gaseous environment 15 or the gas chamber, and an operating mechanism 12, which may be arranged outside the gaseous environment 15.

The gas-insulated high-voltage apparatus 10 may be a switchgear. The solid insulating element 100 may be a push-rod assembly 100, as further shown in Fig. 2, which may be configured to actuate a vacuum interrupter 11 for the gas-insulated high-voltage apparatus 10. The solid insulating element or the push-rod assembly 100 may comprise a surface 115, which is exposing to the gaseous environment 15 and be configured to mechanically support and/or electrically separate the at least one conducting element, and a plurality of surface structures which may be arranged at and integrally forming the surface 115.

In particular, as shown in Fig. 2, the push-body assembly 100 comprises an elongated push-rod body 110 and is configured to actuate a vacuum interrupter 11 for the gas-insulated high-voltage apparatus. Further, the plurality of surface structures comprise a plurality of longitudinal ribs 116, extending along the elongated push-rod body 110.

Fig. 1 and Fig. 2 further show, that the push-rod assembly 100 further comprises a spring cup 120 and a pole insert 130. The spring cup 120 is arranged at a first end of the elongated push-rod body 110 and configured to connect to an operating mechanism 12 and drive the push-rod body 110 towards the vacuum interrupter 11, while the pole insert 130 is arranged at a second end opposite to the first end of the elongated push-rod body 110 and configured to connect to the vacuum interrupter 11. Both the spring cup 120 and the pole insert 130 are received in the elongated push-rod body 110. Accordingly, the surface of the elongated push-rod body 110 may represent as the surface for the whole push-rod assembly 100 exposing to the gaseous environment. The electric potential of the spring cup 120 may be different from that of the pole insert 130. In other words, the spring cup 120 and the pole insert 130 have different electric potentials. Moreover, the spring cup 120 and the pole insert 130 may be made of different materials. The construction and the geometric dimensions of the push-rod body 110 may result in an unevenly distributed electric field stress under the applied voltage or field stress over the surface 115.

In addition, a finite element analysing module (not shown) may be provided for the gas-insulated high-voltage apparatus, which may be configured to analyse the surface 115 and the plurality of surface structures 116 and to determine the plurality of surface structures 116 to be dimensioned and spaced based on at least one geometry constraint of the solid insulating element 100. Further, the plurality of surface structures 116 may be designed to allow generating a mutual shielding among the plurality of surface structures 116 under an electric field stress over the surface 115, in order to reduce the electric field stress at the surface 115 of the solid insulating element 100 below a predetermined electric field stress limit. The at least one geometry constraint of the solid insulating element 100 may comprise a maximum radius of curvature of the plurality of surface structures 116 defined by a manufacturing process of the solid insulating element 100, and/or a maximum wall thickness of the plurality of surface structures 116 and/or the solid insulating element 100 permitted to prevent from an inclusion of gas voids; and/or a mechanical strength requirement defining a minimum cross-sectional dimension of the plurality of surface structures 116 of the solid insulating element 100.

The push-rod assembly 100 as the solid insulating element may be made of a polymer-based insulating material having a relative permittivity greater than the gaseous environment, depending on a manufacturing process, such as an injection molding process. The polymer-based insulating material may be, but not limited to a polyamide, a polyphenylene sulfide or a thermoset resin.

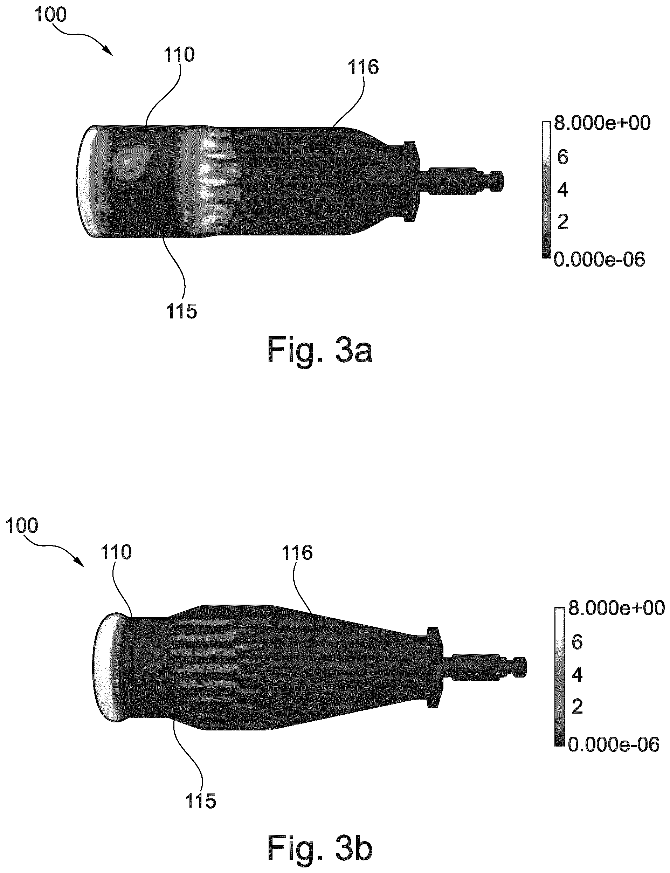

Fig. 3a and Fig. 3b show, respectively, the plurality of longitudinal ribs 116 may be evenly distributed on the outer circumference of the elongated push-rod body 110. The plurality of longitudinal ribs 116 may comprise a first group of ribs surface structures in the vicinity of the pole insert 130, as shown in Fig. 3a and Fig. 3b. Additionally, the plurality of longitudinal ribs 115 may further comprise a second group of ribs surface structures in addition to the first group of ribs surface structures, which are arranged at the surface 115 corresponding to a transition region between the spring cup 120 and the solid push-rod body 110, in particular at an abutting face of the push-rod body 110 for the spring cup 120, as shown in Fig. 3b. Both the first and second groups of ribs surface structures are arranged at and extending along the elongated push-rod body 110, and integrally forming the surface 115 of the elongated push-rod assembly 100.

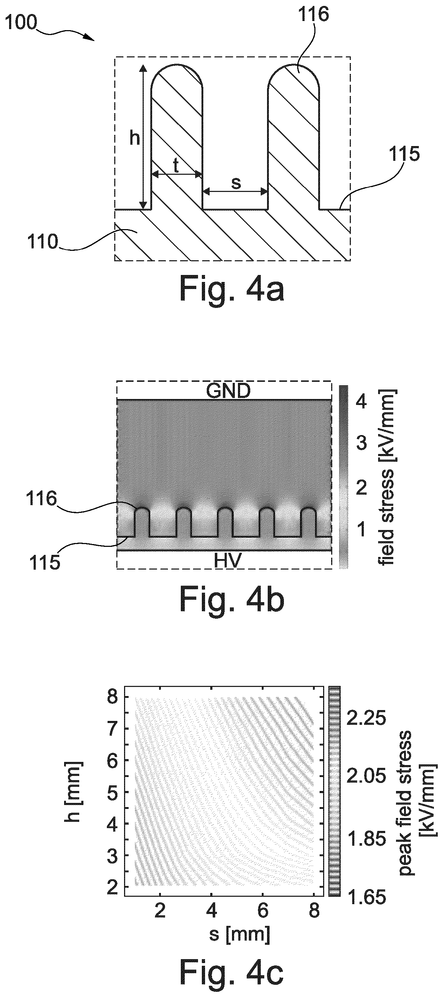

The plurality of surface structures, in particular the second group of longitudinal ribs surface structures 116 may be designed as high-curvature surfaces, as further shown in Fig. 4a, for example by the injection molding process. In Fig. 4a, each of the second group of ribs surface structure 116 of Fig. 3b may comprise a cross-sectional dimension, as determined by means of the finite element analysing module, defining a height h and a wall thickness t. The wall thickness t of each of the second ribs surface structures 116 in Fig. 3b and Fig. 4b is designed to not be thicker than around 4 mm, in order to avoid excessive risk of gas inclusion and voids during the injection molding process used for production of the push-rod assembly 100.

Further, the plurality of longitudinal ribs 116 are equally spaced at the spacing s, determined by means of the finite element analysing module, and designed to allow generating a mutual shielding between adjacent ribs of the plurality of the plurality of longitudinal ribs 116 under the electric field stress, in order to reduce a peak electric field stress at each of the plurality of longitudinal ribs 115 at the surface 115 of the push-rod assembly 100 below a predetermined electric field stress limit. The the finite element analysing module may be configured to determine the spacing s between the adjacent ribs surface structures 116 based on at least one parameter comprising the relative permittivity of the insulting material greater than the gaseous environment, and/or a permissible electric field stress determined by the gas filling the gaseous environment 15 and/or a gas pressure in the gaseous environment 15, and/or a degree of field enhancement determined by permissible dimensions of the plurality of surface structures 116 of the insulating element 100.

In other words, the optimal spacing s between high-curvature surfaces 115, 116 may be adapted to (i) the relative permittivity of the chosen insulator material greater than the gaseous environment, (ii) the permissible field stress as determined by the choice of gas and filling pressure, and (iii) the degree of field enhancement as determined by the permissible dimensions of the insulating structure, which may be determined e.g. by mechanical requirements and the wall thickness that can be achieved at low risk of inclusion of gas bubbles or voids

The resultant field control by self-shielding may advantageously constitute a simple to implement, low-cost alternative to the traditional dedicated field-control electrodes that would have to be included in addition at the price of increased production costs and complexity.

Fig. 3a and Fig. 3b show a concrete example of the insulating push-rod body 110 under a simulated surface electric field stress on two iterations to design or adjust of the dimensions h, t and the spacings s of the ribs surface structures 116 of an insulating push-rod assembly 100 for actuating a vacuum interrupter 11. The push-rod body 110 of Fig. 3a without the second group of ribs surface structures 116 at the surface 115 corresponding the transition region between the spring cup 120 and the push-rod body 130 does not actively exploit the mutual shielding of the mechanically required longitudinal ribs 116, which may be equal to or thinner than 4 mm due to avoid excessive risk of gas inclusion and voids during the injection molding process used for production. Consequently, significant field enhancement and high field stress may occur on the longitudinal ribs with a peak field stress exceeding, for example 2 kV/mm as shown in Fig. 4b and Fig. 4c. This may increase a risk of a discharge inception under the high voltage or field stress applied on the push-rod assembly 100.

Meanwhile the optimized solution in Fig. 3b having the second group of ribs surface structures 116 at the surface 115 corresponding the transition region between the spring cup 120 and the push-rod body 130, in addition to the first group of ribs surface structures in the vicinity of the pole insert 130 uses an adapted and much tighter spacing s of longitudinal ribs to capitalize on their mutual shielding upon voltage application. As a result, the insulating push-rod body 110 of Fig. 3b achieves a reduction of field stress by around 20% with respect to the push-rod body 110 of Fig. 3a, while the part can still be produced using the same production techniques. It may be noted that the high field stress on the push-rod body 110 of Fig. 3a is an artefact of simulating the field distribution for the push-rod body 110 in isolation and does not occur when the push-rod is mounted inside a gas-insulated switchgear.

Fig. 4b shows schematically an example of a two-dimensional model with rib surface structures 116 exposed to a high-voltage potential (HV) and grounded plate (GND) simulating the field shielding effect, and Fig. 4c shows graphically a simulation-based correlation diagram of a peak electric field stress over the surface 115 of the push-rod body 110 relative to the height h and the spacing s of ribs surface structures 116. As shown in Fig. 4b, the peak field structure may appear at the tip region of the high-curvature rib surface structures 116.

As an example, the height h of the plurality of longitudinal ribs 116 of Fig. 4a may be determined, by means of the finite element analysing module, to be in the range of 2 mm to 8 mm. Accordingly, the spacing s between the plurality of longitudinal ribs 116 may be determined, by means of the finite element analysing module, to be less than 6 mm, so that the peak electric field stress at the surface 115 of the push-rod assembly 100 is below the predetermined electric field stress limit of 2 kV/mm, as shown in Fig. 4b and Fig. 4c.

The concept of adaptive rib or insulator surface spacing s may advantageously designed to enhance the dielectric performance without necessitating complex and costly modifications to the assembly and while maintaining the same overall spatial footprint . It may thus tackle the widespread and critical problem of surface discharge inception on insulating mechanical structures arising from field enhancement due to high surface curvatures, as required by manufacturing processes. It permits substantially reducing the electrical stress on such surfaces, which is the key predictor and cause for discharge inception, without increasing the complexity of devices in terms of number of parts, manufacturing processes, or the like.

While Fig. 4b shows the electric field stress in kV/mm for a quasi two-dimensional gas gap with ribbed insulator 100. The peak field stress occurs on the highly curved face of the ribs 116, due to strong local field enhancement, with the schematic depiction of the ribbed insulator with associated dimensions as shown in Fig. 4a, Fig. 4c shows the peak field stress for the rib thickness of 4 mm, which may be appropriate for the injection molding process out of a insulating material of PA or PPS as a function of rib height h and spacing s. Fig. 4c shows that there is a non-trivial relationship between the peak field stress and the rib height h and spacing s, even for this simple geometry.

In other words, using the finite-element simulations of electrical fields to demonstrate the optimal dimensioning of such ribs 116 for given material-related constraints, such as the maximum wall thickness t, the mechanical requirements, for example with the minimal cross-section, and the placement in a general device geometry, Fig. 4c illustrates simulation results for a simple quasi-two-dimensional example, in which a ribbed insulator 100 sits in between two planar electrodes. It shows the peak field stress, which is realized on top of the maximally rounded ribs 116 for the given wall thickness t of 4 mm, as a function of rib height h and spacing s and demonstrates that surface field stresses may be reduced substantially by adapting the spacing s to the rib height h. While the quasi-two-dimensional example appears simple it may constitute a close analogue of the more apparently relevant ribbed body of the push-rod assembly 100 as shown in Fig. 4b. Such simulations may play a key role in calculating and visualizing the electrical stress under defined operational conditions and generalize to different and complex industrial device geometries. More importantly, the concept of exploiting the mutual shielding of the insulator surfaces 115 may generalize to such complex device geometries.

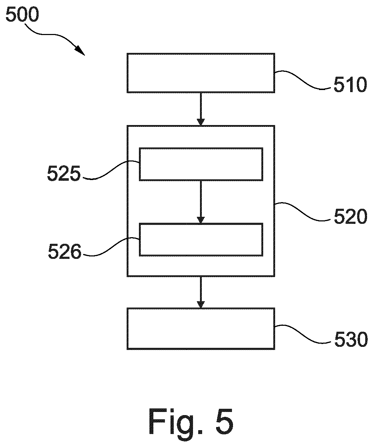

Fig. 5 shows schematically a flow chart illustrating a method 500 for reducing a surface electric field stress for a gas-insulated high-voltage apparatus 10, which comprises at least one conducting element being arranged in at least one gaseous environment 15. The method 500 comprises a plurality of steps.

In a step 510, a solid insulating element 100 is provided, which comprises a surface 115 exposing to the gaseous environment 15 and is configured to mechanically support and/or electrically separate the at least one conducting element and a plurality of surface structures 116 that are arranged at and integrally forming the surface 115.

In a step 520, the surface 115 is analysed and the plurality of the surface structures 116 is determined to be dimensioned and spaced based on at least one geometry constraint of the solid insulating element 100, by means of a finite element analysing module.

In a step 530, it is allowed to generate generating a mutual shielding among the plurality of surface structures 116 under an electric field stress over the surface 115, thereby reducing the electric field stress at the surface 115 of the solid insulating element 100 below a predetermined electric field stress limit.

The at least one geometry constraint of the solid insulating element 100 comprises a maximum radius of curvature of the plurality of surface structures 116 defined by a manufacturing process of the solid insulating element 100, and/or a maximum wall thickness t of the plurality of surface structures 116 and/or the solid insulating element 100 permitted to prevent from an inclusion of gas voids, and/or a mechanical strength requirement defining a minimum cross-sectional dimension of the plurality of surface structures 116 of the solid insulating element 100.

Optionally, the step 520 of analysing the surface 115 and determining, by means of the finite element analysing module, the plurality of the surface structures 116 to be dimensioned and spaced may further comprises a plurality of substeps.

In a substep 525, a spacing s between two adjacent surface structures of the plurality of the surface structures 116 may be determined by means of the finite element analysing module, based on at least one parameter that may comprise: (i) a relative permittivity of an insulting material of the solid insulating element 100 greater than the gaseous environment, and/or (ii) a permissible electric field stress determined by a gas filling the at least one gaseous environment 15, and/or a gas pressure in the at least one gaseous environment 15, and/or (iii) a degree of field enhancement determined by permissible dimensions of the plurality of surface structures 116 of the insulating element 100.

Additionally, in a further optional step 526, a cross-sectional dimension of each of the plurality of surface structures 116, may be determined, by means of the finite element analysing module, which may comprise a height h and the wall thickness t and/or the spacing s between the adjacent surface structures of the plurality of the surface structures 116, in order to reduce the peak electric field stress at the surface 115 below the predetermined electric field stress limit adjusting 526.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SIGNS

- 10: gas-insulated high-voltage apparatus
- 11: vacuum interrupter
- 12: operating mechanism
- 15: gaseous environment
- 100: push-rod assembly / solid insulating element
- 110: elongated push-rod body
- 115: surface of solid insulating element
- 116: longitudinal rib / surface structure
- 120: spring cup
- 130: pole insert
- 122: actuator and sensor component
- 123: swing arm component
- 125: second connecting means
- 128: interior region
- 130: temperature sensing assembly
- h: height
- s: spacing
- w: wall thickness
- 500: method for reducing surface electric field stress for gas-insulated high-voltage apparatus
- 510: step of providing solid insulating element
- 520: step of analysing surface and determining surface structures to be dimensioned and spaced
- 525: step of determining spacing between adjacent surface structures of surface structures
- 526: step of adjusting cross-sectional dimension of each surface structure comprising height and wall thickness and/or spacing between the adjacent surface structures
- 530: step of allowing generating mutual shielding among surface structures under an electric field stress over the surface

## Claims

1. Gas-insulated high-voltage apparatus (10) comprising:
at least one conducting element, arranged in at least one gaseous environment (15),
a solid insulating element (100), comprising
a surface (115), exposing to the gaseous environment (15) and configured to mechanically support and/or electrically separate the at least one conducting element;
a plurality of surface structures (116), arranged at and integrally forming the surface (115), and
a finite element analysing module;
wherein the finite element analysing module is configured to analyse the surface (115) and the plurality of surface structures (116) and to determine the plurality of surface structures (116) to be dimensioned and spaced based on at least one geometry constraint of the solid insulating element (100);
wherein the plurality of surface structures (116) are designed to allow generating a mutual shielding among the plurality of surface structures (116) under an electric field stress over the surface (115), in order to reduce the electric field stress at the surface (115) of the solid insulating element (100) below a predetermined electric field stress limit.

2. The gas-insulated high-voltage apparatus (10) according to claim 1,
wherein the at least one geometry constraint of the solid insulating element (100) comprises:
a maximum radius of curvature of the plurality of surface structures (116) defined by a manufacturing process of the solid insulating element (100); and/or
a maximum wall thickness of the plurality of surface structures (116) and/or the solid insulating element (100) permitted to prevent from an inclusion of gas voids; and/or
a mechanical strength requirement defining a minimum cross-sectional dimension of the plurality of surface structures (116) of the solid insulating element (100).

3. The gas-insulated high-voltage apparatus (10) according to claim 1 or 2,
wherein the plurality of surface structures (116) comprise high-curvature surfaces.

4. The gas-insulated high-voltage apparatus (10) according to any of the preceding claims,
wherein the solid insulating element (100) is made of a polymer-based insulating material having a relative permittivity greater than the gaseous environment;
wherein the polymer-based insulating material is a polyamide or a polyphenylene sulfide or a thermoset resin.

5. The gas-insulated high-voltage apparatus (10) according to claim 4,
wherein the finite element analysing module is configured to determine a spacing (s) between adjacent surface structures of the plurality of surface structures (116) based on at least one parameter comprising:
the relative permittivity of the insulting material greater than the gaseous environment, and/or
a permissible electric field stress determined by a gas filling the at least one gaseous environment (15) and/or a gas pressure in the at least one gaseous environment (15); and/or
a degree of field enhancement determined by permissible dimensions of the plurality of surface structures (116) of the insulating element (100).

6. The gas-insulated high-voltage apparatus (10) according to any of the preceding claims,
wherein the solid insulating element (100) is a push-rod assembly (100), comprising an elongated push-rod body (110) and configured to actuate a vacuum interrupter (11) for the gas-insulated high-voltage apparatus (10);
wherein the plurality of surface structures (116) comprise a plurality of longitudinal ribs at the surface (115) extending along the elongated push-rod body (110).

7. Push-rod assembly (100), configured to actuate a vacuum interrupter (11) for a gas-insulated high-voltage apparatus (10) according to any of the preceding claims 1 to 6, comprising:
an elongated push-rod body (110) being the solid insulating element (100), and
a plurality of longitudinal ribs (116) being the plurality of surface structures, comprising a cross-sectional dimension, determined by means of the finite element analysing module, each having a height (h) and a wall thickness (t), and arranged at and extending along the elongated push-rod body (110), and integrally forming the surface (115) of the elongated push-rod assembly (100);
wherein the plurality of longitudinal ribs (116) are equally spaced at the spacing (s), determined by means of the finite element analysing module, and designed to allow generating a mutual shielding between adjacent ribs of the plurality of longitudinal ribs (116) under the electric field stress, in order to reduce a peak electric field stress at each of the plurality of longitudinal ribs (115) at the surface (115) of the push-rod assembly (100) below a predetermined electric field stress limit.

8. The push-rod assembly (100) according to claim 7, further comprising:
a spring cup (120), arranged at a first end of the elongated push-rod body (110), configured to connect to an operating mechanism (12) and drive the push-rod body (110) towards the vacuum interrupter (11); and
a pole insert (130), arranged at a second end opposite to the first end of the elongated push-rod body (110) and configured to connect to the vacuum interrupter (11);
wherein an electric potential of the spring cup (120) is different from an electric potential of the pole insert (130).

9. The push-rod assembly (100) according to claim 7 or 8,
wherein the wall thickness of each of the plurality of longitudinal ribs (116) is determined, by means of the finite element analysing module, to be equal to or less than 4 mm for preventing from the inclusion of gas voids;
wherein the manufacturing process of the push-rod body (110) is an injection molding process.

10. The push-rod assembly (100) according to any of the preceding claims 7 to 9,
wherein the height (h) of the plurality of longitudinal ribs (116) is determined, by means of the finite element analysing module, to be in the range of 2 mm to 8 mm; and/or
wherein the spacing (s) between the plurality of longitudinal ribs (116) is determined, by means of the finite element analysing module, to be less than 6 mm;
wherein the peak electric field stress at the surface (115) of the push-rod assembly (100) is below the predetermined electric field stress limit of 2 kV/mm.

11. Use of a gas-insulated high-voltage apparatus (10) according to any of the preceding claims 1 to 6 or a push-rod assembly (100) according to any of the preceding claims 7 to 10 for preventing from a discharge inception and dielectric breakdown as a result of a surface electric field stress.

12. Method (500) for reducing a surface electric field stress for a gas-insulated high-voltage apparatus (10), which comprises at least one conducting element being arranged in at least one gaseous environment (15), comprising the steps of:
providing (510) a solid insulating element (100), comprising a surface (115) exposing to the gaseous environment (15) and configured to mechanically support and/or electrically separate the at least one conducting element and a plurality of surface structures (116) being arranged at and integrally forming the surface (115);
analysing (520) the surface (115) and determining, by means of a finite element analysing module, the plurality of surface structures (116) to be dimensioned and spaced based on at least one geometry constraint of the solid insulating element (100);
allowing (530) generating a mutual shielding among the plurality of surface structures (116) under an electric field stress over the surface (115), thereby reducing the electric field stress at the surface (115) of the solid insulating element (100) below a predetermined electric field stress limit;
wherein the at least one geometry constraint of the solid insulating element (100) comprises:
a maximum radius of curvature of the plurality of surface structures (116) defined by a manufacturing process of the solid insulating element (100); and/or
a maximum wall thickness (t) of the plurality of surface structures (116) and/or the solid insulating element (100) permitted to prevent from an inclusion of gas voids; and/or
a mechanical strength requirement defining a minimum cross-sectional dimension of the plurality of surface structures (116) of the solid insulating element (100).

13. The method (500) according to claim 12,
wherein the analysing (520) the surface (115) and determining, by means of the finite element analysing module, the plurality of surface structures (116) to be dimensioned and spaced comprises the substeps of:
determining (525), by means of the finite element analysing module, a spacing (s) between adjacent surface structures of the plurality of surface structures (116) based on at least one parameter comprising:
a relative permittivity of an insulting material of the solid insulating element (100) greater than the gaseous environment, and/or
a permissible electric field stress determined by a gas filling the at least one gaseous environment (15) and/or a gas pressure in the at least one gaseous environment (15); and/or
a degree of field enhancement determined by permissible dimensions of the plurality of surface structures (116) of the insulating element (100);
adjusting (526), by means of the finite element analysing module, a cross-sectional dimension of each of the plurality of surface structures (116) comprising a height (h) and the wall thickness (t) and/or the spacing (s) between the adjacent surface structures of the plurality of surface structures (116), in order to reduce the peak electric field stress at the surface (115) below the predetermined electric field stress limit.

14. A computer program, comprising machine-readable instructions which, when executed by one or more data processing apparatuses comprising a finite element analysing module, cause the one or more data processing apparatuses to perform a method (500) of any one of claims 1 to 13.

15. A data processing system configured to carry out the method (500) of any one of claims 1 to 13.
